(19) Europäisches Patentamt
European Patent Office
Office européen des brevets

(11) **EP 4 718 756 A1**

(12) **EUROPEAN PATENT APPLICATION**
published in accordance with Art. 153(4) EPC

(43) Date of publication:
01.04.2026  Bulletin 2026/14

(21) Application number: 24818261.0

(22) Date of filing: 05.02.2024

(51) International Patent Classification (IPC):
*H04L 1/00* $^{(2006.01)}$

(52) Cooperative Patent Classification (CPC):
H04L 1/00; H04W 28/06

(86) International application number:
PCT/CN2024/076012

(87) International publication number:
WO 2024/250723 (12.12.2024 Gazette 2024/50)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 07.06.2023  CN 202310674811

(71) Applicant: ZTE Corporation
Shenzhen, Guangdong  518057 (CN)

(72) Inventors:
• ZHAO, Wei
  Shenzhen, Guangdong 518057 (CN)
• LI, Liguang
  Shenzhen, Guangdong 518057 (CN)
• XU, Jin
  Shenzhen, Guangdong 518057 (CN)
• LIANG, Chulong
  Shenzhen, Guangdong 518057 (CN)

(74) Representative: Ziebig Hengelhaupt Intellectual
Property Attorneys
Patentanwaltskanzlei PartGmbB
Leipziger Straße 49
10117 Berlin (DE)

(54) **DATA PROCESSING METHOD, APPARATUS, AND STORAGE MEDIUM**

(57)  Embodiments of the present application relate to the technical field of communications, and provide a data processing method, an apparatus, and a storage medium, for use in ensuring the reliability of data transmission and reducing the resource overhead. The method comprises: acquiring m first data packets, wherein m is a positive integer; determining k second data packets according to the m first data packets, wherein k is a positive integer, the value range of elements in a first generator matrix is [0, q-1], and q is a prime or a prime power; encoding the k second data packets according to the first generator matrix to obtain n first encoded data packets, wherein n is a positive integer; and sending all or some first encoded data packets among the n first encoded data packets to a second transmission node.

FIG. 2

EP 4 718 756 A1

**Description**

The present disclosure claims priority to Chinese Patent Application No. 202310674811.9, filed on June 7, 2023, which is hereby incorporated by reference in its entirety.

TECHNICAL FIELD

The present disclosure relates to the technical field of communications, and in particular, to a data processing method, an apparatus, and a storage medium.

BACKGROUND

In the mobile communication with the 5th-generation mobile communication technology (5G), in order to improve reliability of data transmission, automatic retransmission request (ARQ) is used in the radio link control (RLC) layer, and hybrid automatic repeat request (HARQ) is used in the medium access control (MAC) layer to improve the reliability of data transmission. However, the retransmission mechanism may generate great latency, affecting real-time services and resulting in low reliability of data transmission. In addition, in a carrier aggregation (CA) mode or dual connectivity (DC) mode, packet data convergence protocol (PDCP) duplication is used in the 5G mobile communication to improve the reliability through air interface transmission redundancy. However, using PDCP duplication consumes more computing resources. Therefore, how to ensure the reliability of data transmission and reduce resource overhead is a technical problem that needs to be solved urgently.

SUMMARY

A data processing method, an apparatus, and a storage medium are provided in the present disclosure, which are aimed to ensure the reliability of data transmission and reduce the resource overhead.
To achieve the above-mentioned objectives, the following technical solutions are adopted in the present disclosure.
In a first aspect, a data processing method is provided, and the method is applied to a first transmission node, where the method includes:

acquiring m first data packets, where m is a positive integer;
determining k second data packets according to the m first data packets, where k is a positive integer;
performing encoding processing on the k second data packets according to a first generation matrix to obtain n first encoded data packets, where n is a positive integer, and a value range of elements in the first generation matrix is [0, q-1], and q is a prime number or a power of a prime number; and
sending all of the first encoded data packets or a portion of first encoded data packets among the n first encoded data packets to a second transmission node.

In a second aspect, a data processing method is provided, and the method is applied to a second transmission node, where the method includes:

acquiring a number n of first encoded data packets, a number k of second data packets, index identifiers of respective first encoded data packets, and k correctly received first encoded data packets generated by a first transmission node; where k is a positive integer, and the k correctly received first encoded data packets are a subset of the n first encoded data packets obtained by the first transmission node performing encoding on the k second data packets according to a first generation matrix; and
performing processing on the k correctly received first encoded data packets according to the number n of the first encoded data packets, the number k of the second data packets and the index identifiers of the respective first encoded data packets, to obtain a lost second data packet.

In a third aspect, a communication apparatus is provided, and the apparatus includes:

an acquisition unit, configured to acquire m first data packets, where m is a positive integer;
a processing unit, configured to determine k second data packets according to the m first data packets, where k is a positive integer;
the processing unit is further configured to perform encoding processing on the k second data packets according to a first generation matrix to obtain n first encoded data packets, where n is a positive integer, and a value range of elements in the first generation matrix is [0, q-1], and q is a prime number or a power of a prime number; and
a sending unit, configured to send all of the first encoded data packets or a portion of first encoded data packets among the n first encoded data packets to a second transmission node.

In a fourth aspect, a communication apparatus is provided, and the apparatus includes:

an acquisition unit, configured to acquire a number n of first encoded data packets, a number k of second data packets, index identifiers of respective first encoded data packets, and k correctly received first encoded data packets generated by a first transmission node; where k is a positive integer, and the k correctly received first encoded data packets are a subset of the n first encoded data packets obtained by the first transmission node performing encoding on the k second data packets according to a first generation matrix; and
a processing unit, configured to perform processing on the k correctly received first encoded data packets according to the number n of the first encoded data packets, the number k of the second data packets and the index identifiers of the respective first encoded data packets, to obtain a lost second data packet.

In a fifth aspect, there is provided a communication apparatus, which includes: a processor and a memory; where the memory stores instructions that are executable for the processor; the processor is configured to, upon executing the instructions, cause the communication apparatus to implement the method according to any one of the above-mentioned first aspect or the second aspect.

In a sixth aspect, there is provided a computer-readable storage medium. The computer-readable storage medium stores computer instructions, the computer instructions, upon being run on a computer, cause the computer to perform the method according to any one of the above-mentioned first aspect or the second aspect.

In a seventh aspect, there is provided a computer program product including computer instructions. In response that the computer instructions are run on a computer, the computer is caused to perform the method according to any one of the above-mentioned first aspect or the second aspect.

In the embodiments of the present disclosure, since a first encoded data packet is processed according to the first generation matrix, the second transmission node may complete decoding by receiving the k first encoded data packets, thus avoiding the delay caused by repeated data transmission. Moreover, since the first encoded data packet is processed according to the first generation matrix, in a case where a single first data packet is erroneous or lost, the second transmission node may restore the single erroneous or lost first data packet by an Exclusive-OR operation merely according to the received first encoded data packets, thereby reducing the decoding operation amount, and ensuring the reliability of data transmission, and reducing resource overhead.

BRIEF DESCRIPTION OF THE DRAWINGS

The accompanying drawings are used to provide a further understanding of the technical solutions of the present disclosure, and constitute a part of the specification, which is used to explain the technical solutions of the present disclosure together with the embodiments of the present disclosure, and do not constitute a limitation on the technical solutions of the present disclosure.

FIG. 1 is a structural schematic diagram of a communication system provided in the embodiments of the present disclosure.
FIG. 2 is a flowchart of a data processing method provided in the embodiments of the present disclosure.
FIG. 3 is a schematic diagram of composition of a first generation matrix provided in the embodiments of the present disclosure.
FIG. 4 is a schematic diagram for encoding a data packet in a PDCP layer provided in the embodiments of the present disclosure.
FIG. 5 is a schematic diagram for encoding a data packet in a PDCP layer under a DC scenario provided in the embodiments of the present disclosure.
FIG. 6 is a schematic diagram for encoding a data packet in a PDCP layer under a CA scenario provided in the embodiments of the present disclosure.
FIG. 7 is a schematic diagram for encoding a data packet in a RLC layer provided in the embodiments of the present disclosure.
FIG. 8 is a schematic diagram for encoding a data packet in a MAC layer provided in the embodiments of the present disclosure.
FIG. 9 is a schematic diagram for encoding a data packet in a physical layer provided in the embodiments of the present disclosure.
FIG. 10 is a flowchart of another data processing method provided in the embodiments of the present disclosure.

FIG. 11 is a schematic diagram of composition of a communication apparatus provided in the embodiments of the present disclosure.

FIG. 12 is a schematic diagram of composition of another communication apparatus provided in the embodiments of the present disclosure.

FIG. 13 is a structural schematic diagram of a communication apparatus provided in the embodiments of the present disclosure.

DETAILED DESCRIPTION

The technical solutions in the embodiments of the present disclosure will be described below clearly and completely in conjunction with the accompanying drawings. Obviously, the described embodiments are merely a part of the embodiments of the present disclosure, but not all of the embodiments of the present disclosure. All other embodiments obtained based on the embodiments of the present disclosure by those of ordinary skill in the art without paying any creative effort shall be included in the protection scope of the present disclosure.

The terms "first", "second", etc., are merely used for a purpose of description, and are not to be understood as indicating or implying the relative importance or implicitly indicating the number of indicated technical features. Thus, features limited with wordings like "first" or "second," etc., may explicitly or implicitly include one or more of the feature(s). In the description of the present disclosure, wordings "multiple", "a plurality of" or "the plurality of" mean a number of two or more than two unless otherwise specified.

In the embodiments of the present disclosure, wordings, such as "exemplarily" or "for example" and variations thereof, etc., are used to indicate examples, instances, or illustrations. Any embodiment or design solution described in the embodiments of the present disclosure with wordings such as "exemplarily" or "for example" should not be illustrated as being more preferred or advantageous over other embodiments or design solutions. Specifically, the usage of the wordings such as "exemplarily" or "for example" and variations thereof are intended to present relevant concepts in a concrete way.

According to the 5G technical specification (TS) of the 3rd Generation Partnership Project (3GPP), a transmission time interval (TTI) introduced in R15 enables the requirements of air-interface one-way latency with 1 ms and a reliability with $10^{-5}$ are met. The time-sensitive networking (TSN) introduced in R16 enables the requirements of air-interface one-way latency with 0.5-1 ms and a reliability with $10^{-6}$ are met. In the development of B5G (Beyond 5th Generation)/6G (6th Generation) communication technology, there are higher requirements for transmission latency and the reliability of data transmission. In 6G, requirements for the reliability is not less than $10^{-7}$, and even not less than $10^{-9}$.

In related technologies, HARQ is used to improve the reliability of data transmission. However, retransmission may generate a relatively large latency, affecting real-time services and resulting in low data transmission reliability. In addition, in CA or DC mode, PDCP duplication in 5G mobile communications improves the reliability through air interface transmission redundancy. In R15, 2 redundant links are supported, and in R16, up to 4 redundant links are supported. PDCP duplication is suitable for small packets with high reliability services, theoretically increasing reliability from 99% of a single link to 99.99%. However, PDCP repetition involves copying the same data multiple times and transmitting them across different cells or cell groups. PDCP repetition consumes a lot of resources, which is mainly used for data packets with smaller size, but in a case where a size a data packet is relatively large, it may lead to excessive resource consumption. Therefore, how to reduce resource overhead while ensuring the reliability of data transmission is a technical problem that needs to be solved urgently.

Based on this, a data processing method and apparatus, and a storage medium is provided in the embodiments of the present disclosure. After obtaining m first data packets, the first transmission node determines k second data packets according to the m first data packets, so as to make the k second data packets be the same size for encoding. After obtaining the k second data packets, the k second data packets are encoded according to the first generation matrix to obtain n first encoded data packets, and then all of the first encoded data packets or a portion of the first encoded data packets among the n first encoded data packets are sent to the second transmission node. Since a first encoded data packet is processed according to the first generation matrix, the second transmission node may complete decoding by receiving the k first encoded data packets, thus avoiding the delay caused by repeated data transmission. Moreover, since the first encoded data packet is processed according to the first generation matrix, in a case where a single first data packet is erroneous or lost, the second transmission node may restore the single erroneous or lost first data packet by an Exclusive-OR operation merely according to the received first encoded data packets, thereby reducing the decoding operation amount, and implement to ensure the reliability of data transmission, and reducing resource overhead.

The solutions of the embodiments of the present disclosure may be introduced below in conjunction with the accompanying drawings.

The technical solutions provided in the embodiments of the present disclosure may be applied to various mobile communication networks, such as applied to the 5G communication networks. However, it can be understood that in the future development of 6G communication technology, there are higher requirements for data transmission rate, transmission latency, and data transmission reliability. The technical solutions in the embodiments of the present disclosure may also be applied, but is not limited to, 6G communication systems and even higher-level communication systems.

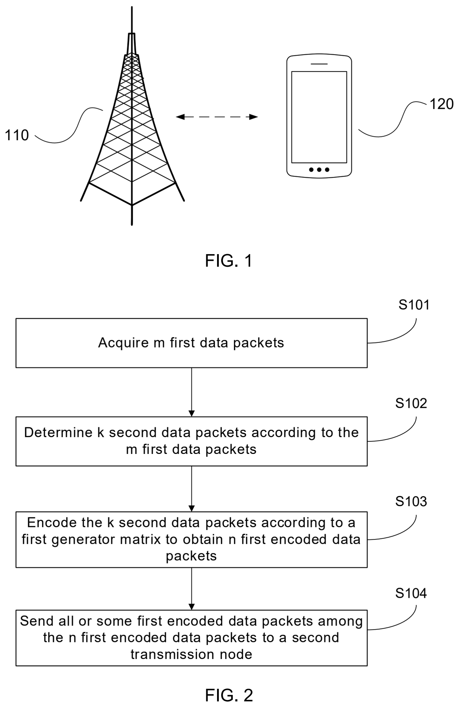

As shown in FIG. 1, FIG. 1 is a structural schematic diagram of a communication system provided in the embodiments of the present disclosure. As shown in FIG. 1, the communication system includes, but not limited to a first transmission node 110 and a second transmission node 120, where transmission, reception or related interactions for wireless signals may be performed between the first transmission node 110 and the second transmission node 120.

In some embodiments, relative positions and quantities of the first transmission node 110 and the second transmission node 120 may be set accordingly in specific application scenarios. For example, the first transmission node 110 may radiate signals outward, and the second transmission node 120 may move along a trajectory formed by the first transmission node 110 radiating signals outward. It can be understood that if there are a plurality of second transmission nodes 120, and different second transmission nodes 120 are arranged in the above manner, wireless signals sent from the first transmission node 110 may be received at different spatial positions. It is worth noting that the spatial positions here may be different geographical conditions.

In some embodiments, the first transmission node 110 or the second transmission node 120 may include, but not limited to, one of the following devices: a base station (BS), an access point (AP), a node B, a g node B (generalized node B), a radio network controller (RNC), an evolved node B (eNB), a base station controller (BSC), a base transceiver station (BTS), a transceiver function (TF), a radio router, a radio transceiver, a basic service set (BSS), an extended service set (ESS) or a radio base station (RBS), which are not limited in this embodiment.

In some embodiments, the first transmission node 110 or the second transmission node 120 may have other names, such as access terminal, user equipment (UE), user unit, user station, mobile station, mobile platform, remote station, remote terminal, mobile device, user terminal, wireless communication device, user agent, or user apparatus, etc. For example, the first transmission node 110 or the second transmission node 120 may be a cellular phone, a cordless phone, a session initiation protocol (SIP) phone, a wireless local loop (WLL) station, a personal digital assistant (PDA), a handheld device with wireless communication capabilities, a computing device or other processing device connected to a wireless modem, a vehicle mounted device, a wearable device, a terminal device in a 5G network or future 5G or above network, etc. This embodiment does not specifically limit this.

In some embodiments, the first transmission node 110 at least has functions of acquiring a first data packet, performing processing on the first data packet to obtain a second data packet, performing encoding on the second data packet according to a first generation matrix to obtain a first encoded data packet, and sending the first encoded data packet to the second transmission node.

In some embodiments, the second transmission node 120 at least has functions of receiving a first encoded data packet sent from the first transmission node 110, and performing processing on the first encoded data packet, where the first encoded data packet is obtained by the first transmission node performing encoding on a second data packet according to the first generation matrix.

In one embodiment, the above functions of the first transmission node 110 or the second transmission node 120 may be applied to different application scenarios, which are not limited herein.

It should be understood that FIG. 1 is an exemplary structural diagram, and a number of devices included in the communication system shown in FIG. 1 is not limited, for example, a number of first transmission node and a number of the second transmission node are not limited. Furthermore, in addition to the devices shown in FIG. 1, the communication system shown in FIG. 1 may further include other devices, which is not limited thereto.

Next, as shown in FIG. 2, a data processing method is provided in the embodiments of the present disclosure, and the method is applied to a first transmission node. The first transmission node may be the first transmission node 110 shown in FIG. 1. The method includes the following S101 to S104.

In S101, m first data packets are acquired.

In some embodiments, in a case where the first transmission node needs to perform data transmission, the first transmission node acquires the m first data packets, where m is a positive integer.

In some embodiments, a first data packet may also have other names, such as a source data packet.

In some embodiments, the first transmission node may acquire the m first data packets from a wireless interface protocol stack. Based on this, the m first data packets include at least one of:

　　a data packet of a PDCP layer in the wireless interface protocol stack;
　　a data packet of a RLC layer in the wireless interface protocol stack;
　　a data packet of a MAC layer in the wireless interface protocol stack;
　　a data packet of a physical layer in the wireless interface protocol stack.

It should be understood that the first transmission node acquires the m first data packets so as to perform encoding subsequently according to a first generation matrix to generate first encoded data packets.

It should be noted that a first data packet may be selected and set according to the specific application scenarios, and is not limited in the embodiments of the present disclosure. Since the manner of acquiring the m first data packets is well known to those skilled in the art, acquiring the m first data packets from the wireless interface protocol stack is merely an example, which will not be described in detail herein.

In S102, k second data packets are determined according to the m first data packets.

Herein, k is a positive integer.

It should be noted that, in the following embodiments, the m first data packets are represented by $b = [b_0; b_1; ...; b_{m-1}]$, where $b_i$ is a row vector, and a size of an i-th first data packet among the m first data packets is $S_i$ bytes. The k second data packets are represented by $a = [a_0; a_1; ...; a_{k-1}]$, where the first data packet $a_i$ is a row vector, and a size of each second data packet is T bytes. A second data packet may also have other names, for example, a source sub-data packet.

As a possible example, determining the k second data packets according to the m first data packets may include at least one of the following implementations.

Implementation 1: in a case where the m first data packets are the same size, the **m first data** packets may be taken as the k second data packets, where m=k.

Implementation 2: in a case where the m first data packets are not the same size, filling processing may be performed on the m first data packets to obtain the k second data packets, where m=k.

As a possible implementation, sizes of first data packets among the m first data packets excluding a target first data packet may be filled to the same size as a size of the target first data packet, where the target first data packet is a data packet with a largest size among the m first data packets.

Exemplarily, the size of the target data packet among the m first data packets is $S_{max}$ bytes, and sizes of the remaining (m-1) first data packets may be filled, so that a size of each first data packet in the remaining (m-1) first data packets is $S_{max}$ bytes. In one example, for an i-th first data packet b_i among the remaining (m-1) first data packets, 0 byte with a quantity of $S_{max} - S_i$ are filled to $b_i$, so as to make the size of $b_i$ become $S_{max}$ bytes. $S_i$ represents a number of bytes of $b_i$.

Implementation 3: in a case where the m first data packets are not the same size, the m first data packets may be performed pre-processing to obtain the k second data packets. Herein, the pre-processing includes at least one of: combining processing, filling processing, and segmenting processing. Exemplarily, performing preprocessing on the m first data packets to obtain the k second data packets may include the following operations.

In A1, combining processing is performed on the m first data packets to obtain a third data packet.

A size of the third data packet is S bytes, $S = \sum_{i=0}^{m-1} S_i$, $S_i$ represents a number of bytes contained of an i-th data packet among the m first data packets, that is, a size of the i-th data packet.

In A2, filling processing is performed on the third data packet to obtain a fourth data packet.

Exemplarily, the third data packet may be filled with 0 byte with a quantity of $k * \mathrm{ceil}\left(\dfrac{S}{k}\right) - S$ to obtain the fourth data packet, and the fourth data packet includes $k * \mathrm{ceil}\left(\dfrac{S}{k}\right)$ bytes. Herein, ceil() represents a smallest integer greater than or equal to a value in the bracket.

In A3, segmenting processing is performed on the fourth data packet to obtain the k second data packets.

After obtaining the fourth data packet, segmenting processing may be performed on the fourth data packet to obtain the k second data packets, a size of each of the second data packets is $\mathrm{ceil}\left(\dfrac{S}{k}\right)$ bytes.

It should be understood that the combining process, the filling process, and the segmenting process may have different orders, and there may be one of the processes, or may be a combination of a plurality of processes.

As an example, combining processing may be performed on the m first data packets to obtain the k second data packets, where respective second data packets after being performed the combining processing are the same size.

As another example, filling processing is performed on the m data packets to obtain the k second data packets, where respective second data packets after being performed the filling processing are the same size.

As yet another example, segmenting processing is performed on the m data packets to obtain the k second data packets, where respective second data packets after being performed the segmenting processing are the same size.

As yet another example, combining processing and filling processing are performed on the m data packets to obtain the k second data packets, where respective second data packets after being performed the combining processing and the filling processing are the same size.

As yet another example, combining processing and segmenting processing are performed on the m data packets to obtain the k second data packets, where respective second data packets after being performed the combining processing and the segmenting processing are the same size.

As yet another example, filling processing and segmenting processing are performed on the m data packets to obtain the k second data packets, where respective second data packets after being performed the filling processing and the segmenting processing are the same size.

In some embodiments, a number k of the second data packets is determined according to at least one of: a number m of the first data packets, a size S of the m first data packets, a size T of a second data packet, channel state information, capability information of a user equipment, a control signaling, a number of links and a number of carriers.

Herein, the channel state information includes at least one of the following: channel quality indication information, rank indication information or precoding matrix indication information; the capability information of the user equipment includes at least one of: an upper limit value of a number of antennas supported by the user equipment, an upper limit value of a data transmission rate supported by the user equipment, or an upper limit value of a modulation order supported by the user equipment. The user equipment is the second transmission node, and the capability information of the user equipment is also the capability information of the second transmission node.

As an example, in a case where the number k of second data packets is determined according to the channel state information, at least one of the following implementations may be included.

Implementation 1: in a case where the channel state information is channel quality indication information, the number k of the second data packets is determined according to an index value of the channel quality indication information. For example, in a case where an index value of the channel quality indication is an integer from 1 to 5, the number k of second data packets is a first preset value, in a case where the index value of the channel quality is an integer from 6 to 10, the number k of second data packets is a second preset value, and in a case where the index value of the channel quality is an integer from 11 to 15, the number k of second data packets is a third preset value. Herein, the first preset value, the second preset value, and the third preset value are all positive integers. In one example, the first preset value is equal to 5, the second preset value is equal to 10, and the third preset value is equal to 15.

Implementation 2: in a case where the channel state information is the rank indication information, the number k of second data packets is determined according to a value of the rank indication information. For example, in a case where the value of the rank indication information is equal to 1 or 2, the number k of second data packets is a fourth preset value, in a case where the value of the rank indication information is equal to 3, the number k of second data packets is a fifth preset value, and in a case where the value of the rank indication information is equal to 4, the number k of second data packets is a sixth preset value. Herein, the fourth preset value, the fifth preset value, and the sixth preset value are all positive integers. In one example, the fourth preset value is equal to 5, the fifth preset value is equal to 10, and the sixth preset value is equal to 15.

Implementation 3: in a case where the channel state information is the precoding matrix indication information, the number k of the second data packets is determined according to an index value of the precoding matrix indication information. For example, for a single-layer transmission with four antenna ports with transform precoding, in a case where an index value of a transmission precoding matrix indication is an integer from 0 to 7, the number k of the second data packets is a seventh preset value, in a case where the index value of the transmission precoding matrix indication is an integer from 8 to 15, the number k of the second data packets is an eighth preset value, and in a case where the index value of the transmission precoding matrix indication is an integer from 16 to 27, the number k of the second data packets is a ninth preset value. Herein, the seventh preset value, the eighth preset value, and the ninth preset value are all positive integers. In one example, the seventh preset value is equal to 5, the eighth preset value is equal to 10, and the ninth preset value is equal to 15.

As an example, in a case where the number k of second data packets is determined according to the capability information of the user equipment, at least one of the following implementations may be included.

Implementation 1: in a case where the capability information of the user equipment is the upper limit value of the number of antennas supported by the user equipment, and in a case where the upper limit value of the number of antennas supported by the user equipment is greater than a first threshold w1, that is, a maximum number of antennas supported by the user equipment is greater than the first threshold w1, then the number k of second data packets is a tenth preset value, otherwise the number of second data packets is an eleventh preset value, where w1 is equal to one of the following: 4, 6, 8, 12, or 16. Herein, the tenth preset value and the eleventh preset value are positive integers. In one example, the tenth preset value is equal to 20, and the eleventh preset value is equal to 10.

Implementation 2: in a case where the capability information of the user equipment is the upper limit value of the data transmission rate supported by the user equipment, and in a case where the upper limit value of the data transmission rate supported by the user equipment is greater than a second threshold w2, that is, in a case where a supported maximum data transmission rate supported by the user equipment is greater than the second threshold w2, the number of second data packets is a twelfth preset value, otherwise the number of second sub-data packets is a thirteenth preset value, where w2 is equal to one of the following: 500 Mbps, 1 Gbps, or 10 Gbps. Herein, the twelfth preset value and the thirteenth preset value are positive integers. In one example, the twelfth preset value is equal to 5, and the thirteenth preset value is equal to 10.

Implementation 3: in a case where the capability information of the user equipment is the upper limit value of the modulation order supported by the user equipment, and in a case where the upper limit value of the modulation order supported by the user equipment is greater than a third threshold w3, that is, a maximum modulation order supported by the user equipment is greater than the third threshold w3, then the number of second data packets is a fourteenth preset value, otherwise the number of second data packets is a fifteenth preset value, where w3 is equal to one of the following: 4, 6, 8, or 10. Herein, the fourteenth preset value and the fifteenth preset value are positive integers. In one example, the fourteenth preset value is equal to 5, and the fifteenth preset value is equal to 10.

As yet another example, in a case where the number k of second data packets is determined according to the control signaling, the control signaling is used to indicate the number k of second data packets.

Exemplarily, the control signaling indicates the number of second data packets using p bits, where p is an integer greater than 0, and the p bits indicate the number of $2^p$ types of second data packets at most. In one possible example, in a case of p=1, there are two types of numbers of second data packets for selecting: "0" indicates that the number of second data packets is a sixteenth preset value, and "1" indicates that the number of second data packets is a seventeenth preset value. Herein, the sixteenth preset value and the seventeenth preset value are positive integers. In one example, the sixteenth preset value is equal to 6, and the seventeenth preset value is equal to 12.

As yet another example, in a case where the number k of second data packets is determined according to the number of links, the number k of second data packets is determined according to a number of an entity and a number of another entity that is associated with the entity indicated by the number of links. Taking the number of links representing a number of RLC entities that are associated with one PDCP entity as an example, in a case where one PDCP entity is associated with two RLC entities, the number of second data packets is a eighteenth preset value. In a case where one PDCP entity is associated with four RLC entities, the number of the second data packets is a nineteenth preset value. Herein, the eighteenth preset value and the nineteenth preset value are positive integers. In one example, the eighteenth preset value is equal to 8, and the nineteenth preset value is equal to 16.

As yet another example, in a case where the number k of second data packets is determined according to the number of carriers, different numbers of carriers correspond to different numbers k of second data packets, and each carrier corresponds to an independent cell. For example, if the number of carriers is 2, the number of the second data packets is a twentieth preset value. For another example, if the number of carriers is 4, then the number of second data packets is a twenty-first preset value. Herein, the twentieth preset value and the twenty-first preset value are positive integers. In one example, the twentieth preset value is equal to 6, and the twenty-first preset value is equal to 12.

As yet another example, in a case where the number k of second data packets is determined according to the number m of first data packets, different ranges of m correspond to different numbers k of second data packets. In one possible example, in a case where the range of m is within a range [m1, m2], the number of second data packets is a twenty-second preset value; in a case where the range of m is within a range (m2, m3), the number of second data packets is a twenty-third preset value, where m1, m2, and m3 are positive integers and m1<m2<m3. Herein, the twenty-second preset value and the twenty-third preset value are positive integers. In one example, the twenty-second preset value is equal to 4, and the twenty-third preset value is equal to 8.

As yet another example, in a case where the number k of the second data packets is determined according to the size S of the first data packet, different ranges of S correspond to different numbers k of the second data packets. In one possible example, in a case where the range of S is within a range [s1, s2], the number of second data packets is a twenty-fourth preset value; in a case where the range of S is within a range (s2, s3], the number of second data packets is a twenty-fifth preset value, where s1, s2, and s3 are positive integers and s1<s2<s3. Herein, the twenty-fourth preset value and the twenty-fifth preset value are positive integers. In one example, the twenty-fourth preset value is equal to 4, and the twenty-fifth preset value is equal to 8.

As another example, in a case where the number k of second data packets is determined according to the size T of a second data packet, different ranges of T correspond to different numbers k of second data packets. In one possible example, in a case where the range of T is within a range [t1, t2], the number of second data packets is a twenty-sixth preset value, and in a case where the range of S is within a range (t2, t3], the number of second data packets is the twenty-seventh preset value, where t1, t2, and t3 are positive integers and t1<t2<t3. Herein, the twenty-sixth preset value and the twenty-seventh preset value are positive integers. In one example, the twenty-sixth preset value is equal to 6, and the twenty-seventh preset value is equal to 12.

It should be understood that the sizes of the m first data packets may be different. In a case of performing encoding processing subsequently according to the first generation matrix, if the sizes of the m first data packets are different, encoding processing may not be successfully performed. Based on this, in the embodiments of the present disclosure, the m first data packets are processed to obtain the k second data packets, and the k second data packets are the same size, so that the k second data packets with the same size may be smoothly encoded according to the first generation matrix subsequently, thereby ensuring the reliability of data transmission.

In S103, encoding processing is performed on the k second data packets according to a first generation matrix to obtain n first encoded data packets.

Herein, n is a positive integer, a value range of elements in the first generation matrix is [0, q-1], and q is a prime number or a power of a prime number.

In some embodiments, the first generation matrix may be preconfigured, or may be determined according to the number k of second data packets and/or the number n of first encoded data packets.

In some embodiments, the first generation matrix G includes an identity matrix I and a second generation matrix $G_2$, a size of the identity matrix I is k×k, a size of the second generation matrix $G_2$ is r×k, and n=r+k, where r is a positive integer. Based on this, the n first encoded data packets include k second data packets and r second encoded data packets, and the r second encoded data packets are data packets obtained by performing encoding on the k second data packets according to the second generation matrix.

In some embodiments, a second encoded data packet may also have other names, for example, a second encoded data packet may also be called a check data packet.

In some embodiments, a number r of the second encoded data packets is determined according to at least one of: a number k of the second data packets, channel state information, and a control signaling; where the channel state information includes at least one of: channel quality indication information, rank indication information, or precoding matrix indication information.

As an example, in a case where the number r of second encoded data packets is determined according to the number k of second data packets, each value range of the number k of second data packets corresponds to a value of the number r of second encoded data packets. For example, in a case where the number k of the second data packets is in a value range [k1, k2], r is a twenty-eighth preset value. Herein, k1 and k2 are two different positive integers, and the twenty-eighth preset value may be different values in different value ranges of k. In one example, k1 = 4, k2 = 8, and the twenty-eighth preset value is equal to 2.

As another example, determining the number r of second encoded data packets according to the channel state information may be according to at least one of the following implementations.

Implementation 1: in a case where the channel state information is channel quality indication information, the number k of the second encoded data packets is determined according to an index value of the channel quality indication information. For example, in a case where an index value of the channel quality indication is an integer from 1 to 5, the number r of second encoded data packets is a twenty-ninth preset value, in a case where the index value of the channel quality is an integer from 6 to 10, the number r of second encoded data packets is a thirtieth preset value, and in a case where the index value of the channel quality is an integer from 11 to 15, the number r of second encoded data packets is a thirty-first preset value. Herein, the twenty-ninth preset value, the thirtieth preset value, and the thirty-first preset value are all positive integers. In one example, the twenty-ninth preset value is equal to 2, the thirtieth preset value is equal to 3, and the thirty-first preset value is equal to 4.

Implementation 2: in a case where the channel state information is the rank indication information, the number r of second encoded data packets is determined according to a value of the rank indication information. For example, in a case where the value of the rank indication information is equal to 1 or 2, the number r of second encoded data packets is a thirty-second preset value, in a case where the value of the rank indication information is equal to 3, the number r of second encoded data packets is a thirty-third preset value, and in a case where the value of the rank indication information is equal to 4, the number k of second data packets is a thirty-fourth preset value. Herein, the thirty-second preset value, the thirty-third preset value, and the thirty-fourth preset value are all positive integers. In one example, the thirty-second preset value is equal to 2, the thirty-third preset value is equal to 3, and the thirty-fourth preset value is equal to 4.

Implementation 3: in a case where the channel state information is the precoding matrix indication information, the number r of the second encoded data packets is determined according to an index value of the precoding matrix indication information. For example, for a single-layer transmission with four antenna ports with transform precoding, in a case where an index value of a transmission precoding matrix indication is an integer from 0 to 7, the number r of the second encoded data packets is a thirty-fifth preset value, in a case where the index value of the transmission precoding matrix indication is an integer from 8 to 15, the number r of the second encoded data packets is a thirty-sixth preset value, and in a case where the index value of the transmission precoding matrix indication is an integer from 16 to 27, the number r of the second encoded data packets is a thirty-seventh preset value. Herein, the thirty-fifth preset value, the thirty-sixth preset value, and the thirty-seventh preset value are all positive integers. In one example, the thirty-fifth preset value is equal to 2, the thirty-sixth preset value is equal to 3, and the thirty-seventh preset value is equal to 4.

As yet another example, in a case where the number r of second encoded data packets is determined according to the control signaling, the control signaling is used to indicate the number r of second encoded data packets.

Exemplarily, the control signaling indicates the number r of second encoded data packets using x bits, where x is an integer greater than 0, and the x bits indicate the number of $2^x$ types of second encoded data packets at most. In one possible example, in a case of x=1, there are two types of numbers of second encoded data packets for selecting: "0" indicates that the number of second encoded data packets is a thirty-eighth preset value, and "1" indicates that the number of second encoded data packets is a thirty-ninth preset value. Herein, the thirty-eighth preset value and the thirty-ninth preset value are positive integers. In one example, the thirty-eighth preset value is equal to 2, and the thirty-ninth preset value is equal to 4.

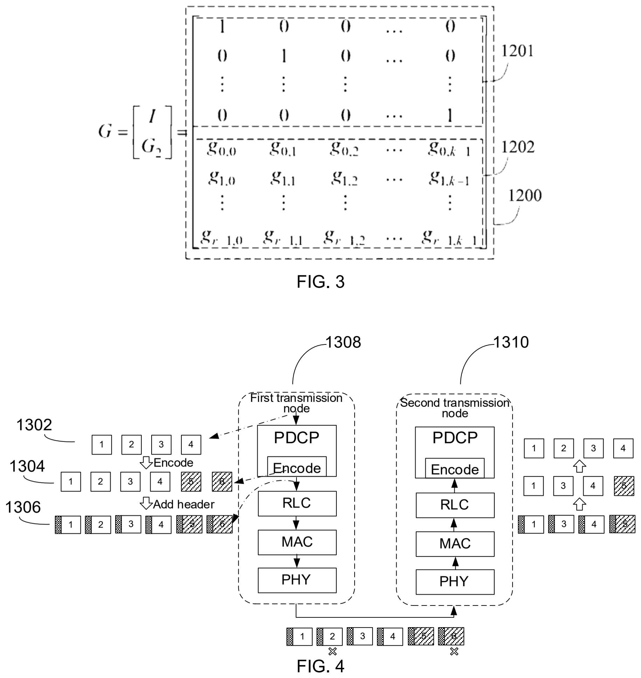

In some embodiments, as shown in FIG. 3, FIG. 3 is a schematic diagram of composition of a first generation matrix provided in the embodiments of the present disclosure. Referring to FIG. 3, the first generation matrix 1200 consists of an identity matrix 1201 and a second generation matrix 1202. $g_{i,j}$ is an element value under the Galois field GF(q), and $0 \leq i \leq r-1$, $0 \leq j \leq k-1$. The size q of the Galois field is a prime number or a power of a prime number, for example, q includes, but not limited to 2, 4, 8, 16, 32, 64, 128, 256, 512.

In some embodiments, for any k rows in the first generation matrix, the any k rows are linearly independent under the Galois Field GF(q). That is, a submatrix with a size of $k \times k$ consisting of the any k rows of the first generation matrix is reversible under the Galois Field GF(q).

It should be understood that any k rows in the first generation matrix are linearly independent under the Galois field GF(q), that is, the submatrix consisting of any k rows in the first generation matrix is reversible, in order to ensure maximum distance separable (MDS), that is, to ensure that in a case where any r first encoded data packets among the n first encoded data packets fail, the k second data packets are capable of being successfully decoded, thereby ensuring the reliability of data transmission.

In some embodiments, there is a target row in the second generation matrix, and values of elements in the target row are all 1. That is, there is a row in the second generation matrix in which all elements have values of 1.

In some embodiments, the check data packet obtained by performing encoding on the k second data packets according to the target row may also be referred to as a third encoded data packet.

It should be understood that in a case where a single second data packet is lost among the n first encoded data packets, since there is a row in the second generation matrix whose element values are all 1, the single lost second data packet may be quickly restored through an Exclusive-OR operation (which is faster than multiplication). Since the amount of calculation of the Exclusive-OR operation is lower than that of multiplication, resource overhead is reduced.

In some embodiments, for any r columns in a merged matrix consisting of the second generation matrix and the identity matrix of size $r \times r$, any r columns are linearly independent under the Galois field GF(q).

As an example, an identity matrix (with a size of $r \times r$) may be added to the right side of the second generation matrix (with a size of $r \times k$) to form a merge matrix with a size of $r \times n$ (n=r+k), where n is the number of first encoded data packets.

In some embodiments, the merge matrix may also be referred to as a check matrix.

It should be understood that a generation matrix and a check matrix may be understood as descriptions of the same encoding method from different perspectives, and the characteristics of the encoding method may be described by either the generation matrix or the check matrix.

As a possible example, the value of the element with row number i and column number j in the second generation matrix is determined according to the following parameters: k, i, j; where i and j are both non-negative integers, and $0 \leq i \leq r-1$, $0 \leq j \leq k-1$.

As another possible example, a value of an element with a row number i and a column number j in the second generation matrix is determined according to the following formula:

$$g_{i,j} = (k+j)/(k+i+j);$$

where $g_{i,j}$ represents the value of the element with the row number i and the column number j in the second generation matrix, i and j are both non-negative integers, and $0 \leq i \leq r-1$, $0 \leq j \leq k-1$, / represents a division operation under the Galois field GF(q), and + represents a bitwise Exclusive-OR operation under the Galois field GF(q).

As an example, the second generation matrix $G_2$ may be as shown in the following formula:

$$G_2 = \begin{bmatrix} \dfrac{1}{k+0} & \dfrac{1}{k+1} & \dfrac{1}{k+2} & \cdots & \dfrac{1}{k+k-1} \\ \dfrac{k+1+0}{\vdots} & \dfrac{k+1+1}{\vdots} & \dfrac{k+1+3}{\vdots} & \ddots & \dfrac{k+1+k-1}{\vdots} \\ \dfrac{k+0}{n-1+0} & \dfrac{k+1}{n-1+1} & \dfrac{k+2}{n-1+2} & \cdots & \dfrac{k+k-1}{n-1+k-1} \end{bmatrix}$$

For example, taking a size q of the Galois field being equal to 256, a source data blocks k=5, and a number r of second encoded data blocks being equal to 2 as an example, the second generation matrix $G_2$ may be shown as follows:

$$G_2 = \begin{bmatrix} \dfrac{1}{143} & \dfrac{1}{210} & \dfrac{1}{200} & \dfrac{1}{245} & \dfrac{1}{142} \end{bmatrix}$$

In some embodiments, any two columns or two rows in the second generation matrix may be exchanged, that is, the second generation matrix may be obtained by exchanging any two columns or two rows in the second generation matrix.

As a possible example, any two rows or two columns of a matrix obtained according to the formula $g_{i,j} = (k+j)/(k+i+j)$ are exchanged to obtain the second generation matrix, where $g_{i,j}$ represents a value of an element with a row number i and a column number j in the matrix, i and j are both non-negative integers, and $0{\le}i{\le}r-1$, $0{\le}j{\le}k-1$, / represents a division operation under the Galois field GF(q), and + represents a bitwise Exclusive-OR operation under the Galois field GF(q).

For example, taking a size q of the Galois field being equal to 256, a source data blocks k=5, and a number r of second encoded data blocks being equal to 2, and exchanging a first row and a second row of a matrix obtained according to a formula $g_{i,j} = (k+j)/(k+i+j)$ as an example, the second generation matrix $G_2$ may be shown as follows.

$$G_2 = \begin{bmatrix} 143 & 210 & 200 & 245 & 142 \\ 1 & 1 & 1 & 1 & 1 \end{bmatrix}$$

As another possible example, a value of an element with a row number i and a column number j in the second generation matrix is determined according to the following formula:

$$g_{i,j} = ((k+j)*(k+i))/((k+i+j)*k);$$

where $g_{i,j}$ represents the value of the element with the row number i and the column number j in the second generation matrix, / represents a division operation under the Galois field GF(q), and + represents a bitwise Exclusive-OR operation under the Galois field, * represents a multiplication operation under the Galois field GF(q).

As an example, the second generation matrix $G_2$ may be as shown in the following formula:

$$G_2 = \begin{bmatrix} 1 & 1 & 1 & \cdots & 1 \\ 1 & \dfrac{k+1}{k+1+1}\cdot\dfrac{k+1+0}{k+0} & \dfrac{k+2}{k+1+2}\cdot\dfrac{k+1+0}{k+2+0} & \cdots & \dfrac{k+k-1}{k+1+k-1}\cdot\dfrac{k+1+0}{k+2+0} \\ 1 & \dfrac{k+1}{k+2+1}\cdot\dfrac{k+0}{k+0} & \dfrac{k+2}{k+2+2}\cdot\dfrac{k+0}{k+0} & \cdots & \dfrac{k+k-1}{k+2+k-1}\cdot\dfrac{k+0}{k+0} \\ \vdots & \vdots & \vdots & \ddots & \vdots \\ 1 & \dfrac{k+1}{n-1+1}\cdot\dfrac{n-1+0}{k+0} & \dfrac{k+2}{n-1+2}\cdot\dfrac{n-1+0}{k+0} & \cdots & \dfrac{k+k-1}{n-1+k-1}\cdot\dfrac{n-1+0}{k+0} \end{bmatrix}$$

For example, taking a size q of the Galois field being equal to 256, a source data blocks k=5, and a number r of second encoded data blocks being equal to 2 as an example, the second generation matrix $G_2$ may be shown as follows:

$$G_2 = \begin{bmatrix} 1 & 1 & 1 & 1 & 1 \\ 1 & 156 & 123 & 166 & 244 \end{bmatrix}$$

As a possible example, any two rows or two columns of a matrix obtained according to the formula $g_{i,j} = ((k+j)*(k+i))/((k+i+j)*k)$ are exchanged to obtain the second generation matrix, where $g_{i,j}$ represents a value of an element with a row number i and a column number j in the matrix, i and j are both non-negative integers, and $0{\le}i{\le}r-1$, $0{\le}j{\le}k-1$, / represents a division operation under the Galois field GF(q), and + represents a bitwise Exclusive-OR operation under the Galois field GF(q).

For example, taking a size q of the Galois field being equal to 256, a source data blocks k=5, and a number r of second encoded data blocks being equal to 2, and exchanging a first column and a second column of a matrix obtained according to a formula $g_{i,j} = ((k+j)*(k+i))/((k+i+j)*k)$ as an example, the second generation matrix $G_2$ may be shown as follows.

$$G_2 = \begin{bmatrix} 1 & 1 & 1 & 1 & 1 \\ 156 & 1 & 123 & 166 & 244 \end{bmatrix}$$

In some embodiments, encoding the k source data blocks according to the second generation matrix to obtain the n first encoded data blocks is determined according to the following formula:

$$\mathrm{d} = [a; \mathrm{G}_2 * a];$$

where d represents the n first encoded data blocks, $\mathrm{G}_2$ represents the first generation matrix, * represents a matrix multiplication operation under the Galois field GF(q), $a$ represents the k source data blocks, and $a = [a_0, a_1, ..., a_{k-1}]^T$. d = $[d_0, d_1, ..., d_{n-1}]^T = [a_0, a_1, ..., a_{k-1}, h_0, h_1, ..., h_{r-1}]^T$, where $h_j$ represents a j-th second encoded data block among the r second encoded data blocks, where j is a non-negative integer smaller than r, and $T$ represents transposition.

In some embodiments, the n first encoded data packets are determined according to the following formula:

$$\mathrm{d} = G * a;$$

where d represents the n first encoded data packets, $G$ represents the first generation matrix, * represents a matrix multiplication operation under the Galois field GF(q), $a$ represents the k second data packets, and $a = [a_0, a_1, ..., a_{k-1}]^T$. Since the first k rows of the first generation matrix form an identity matrix, the first k first encoded data packets among the n first encoded data packets have the same value as values of the k second data packets, d = $[d_0, d_1, ..., d_{n-1}]^T = [a_0, a_1, ..., a_{k-1}, h_0, h_1, ..., h_{r-1}]^T$. Herein, $T$ represents transposition, $[d_k, d_{k+1}, ..., d_{n-1}] = [h_0, h_1, ..., h_{r-1}]$, $h_j$ represents a j-th second encoded data packet among the r second encoded data packets, where j is a non-negative integer smaller than r.

For example, taking a size q of the Galois field size being equal to 256, a number k of second data packets being equal to 5, the number r of second encoded data packets being equal to 2, and each second data packet including 2 bytes as an example, the k second data packets may be shown as follows.

$$a = \begin{bmatrix} 168 & 194 \\ 10 & 190 \\ 217 & 101 \\ 239 & 168 \\ 174 & 44 \end{bmatrix}$$

In some embodiments, in a case where $g_{i,j} = (k+j)/(k+i+j)$, the n first encoded data packets may be determined according to the following relationship.

$$\mathrm{d} = G * a = \begin{bmatrix} 1 & 0 & 0 & 0 & 0 \\ 0 & 1 & 0 & 0 & 0 \\ 0 & 0 & 1 & 0 & 0 \\ 0 & 0 & 0 & 1 & 0 \\ 0 & 0 & 0 & 0 & 1 \\ 1 & 1 & 1 & 1 & 1 \\ 143 & 210 & 200 & 245 & 142 \end{bmatrix} * \begin{bmatrix} 168 & 194 \\ 10 & 190 \\ 217 & 101 \\ 239 & 168 \\ 174 & 44 \end{bmatrix} = \begin{bmatrix} 168 & 194 \\ 10 & 190 \\ 217 & 101 \\ 239 & 168 \\ 174 & 44 \\ 58 & 157 \\ 199 & 158 \end{bmatrix}$$

In some embodiments, in a case where $g_{i,j} = ((k+j) * (k+i))/((k+i+j) * k)$, the n first encoded data packets may be determined according to the following relationship.

$$\mathrm{d} = G * a = \begin{bmatrix} 1 & 0 & 0 & 0 & 0 \\ 0 & 1 & 0 & 0 & 0 \\ 0 & 0 & 1 & 0 & 0 \\ 0 & 0 & 0 & 1 & 0 \\ 0 & 0 & 0 & 0 & 1 \\ 1 & 1 & 1 & 1 & 1 \\ 1 & 156 & 123 & 166 & 244 \end{bmatrix} * \begin{bmatrix} 168 & 194 \\ 10 & 190 \\ 217 & 101 \\ 239 & 168 \\ 174 & 44 \end{bmatrix} = \begin{bmatrix} 168 & 194 \\ 10 & 190 \\ 217 & 101 \\ 239 & 168 \\ 174 & 44 \\ 58 & 157 \\ 113 & 31 \end{bmatrix}$$

In some embodiments, the r second encoded data packets may be obtained according to the following formula.

$$h = G_2 * a;$$

where $h$ represents the r second encoded data packets, $G_2$ is the second generation matrix, and $a$ is the k second data packets. Then, the k second data packets and the r second encoded data packets are merged to obtain the n first encoded data packets, where d = $[d_0, d_1, ..., d_{n-1}]^T = [a_0, a_1, ..., a_{k-1}, h_0, h_1, ..., h_{r-1}]^T$, $T$ represents transposition.

In some embodiments, the first transmission node performing encoding processing on the k second data packets to obtain the n first encoded data packets. Herein, a second data packet may come from a data packet of one of the following sublayers in the wireless interface protocol stack: a PDCP layer, a RLC layer, a MAC layer, a physical layer.

As an example, in a case where a second data packet comes from the PDCP layer, the second data packet is obtained according to a service data unit (SDU) data packet of the PDCP layer.

Exemplarily, as shown in FIG. 4, FIG. 4 is a schematic diagram for encoding a data packet in the PDCP layer provided in the embodiments of the present disclosure. Referring to FIG. 4, the first transmission node 1308 performs encoding on second data packets 1302, the number of second data packets 1302 is k, k is an integer greater than 0, and as shown in FIG. 4, k being 4 is shown as an example. The k second data packets 1302 are encoded according to the first generation matrix to obtain the n first encoded data packets 1304, n is an integer greater than k, and as shown in FIG. 4, n being 6 is shown as an example. Then the first encoded data packets 1304 are added PDCP headers to obtain the PDUs 1306 of the PDCP, which are transmitted to the RLC layer via the RLC channel. Then, the second transmission node 1310 receives the first encoded data packets 1, 3, 4, and 5, where the first encoded data packet 5 is a third encoded data packet. The PDCP headers are removed at the PDCP layer of the second transmission node 1310, and the second data packets may be restored by decoding by Exclusive-OR operation; where the white framed parts 1302 represent the second data packets, the black part on the left of 1306 represents the data packet headers, and the lower left slashed parts in 1304 and 1306 represent the second encoded data packets.

It should be noted that in FIG. 4, "Encode" means encoding, "Add header" means adding a header, and PHY means a physical layer "physics".

The second data packets being acquired according to the SDU data packet of the PDCP layer is illustrated below in different scenarios.

Scenario 1: taking the second data packets being acquired according to the SDU data packet of the PDCP layer under the DC scenario as an example for explanation.

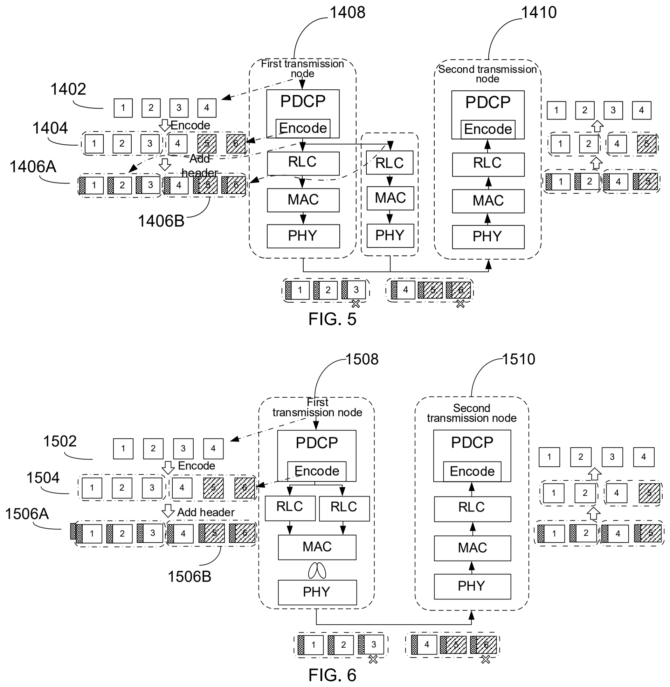

Exemplarily, as shown in FIG. 5, FIG. 5 is a schematic diagram for encoding a data packet in a PDCP layer under a DC scenario provided in the embodiments of the present disclosure. Referring to FIG. 5, the first transmission node 1408 performs encoding on second data packets 1402, the number of second data packets 1402 is k, k is an integer greater than 0, and as shown in FIG. 5, k being 4 is shown as an example. The k second data packets 1402 are encoded according to the first generation matrix to obtain the n first encoded data packets 1404, n is an integer greater than k, and as shown in FIG. 5, n being 6 is shown as an example. Then the first encoded data packets 1404 are added PDCP headers to obtain the PDUs of the PDCP. In the DC scenario, the encoded PDCP PDUs are divided according to a channel state information-reference signal (CSI-RS), downlink control information (DCI), and other channel state information, and a cell with good channel quality or an idle cell may carry more first encoded data packets. In FIG. 5, six first encoded data packets 1404 are obtained by encoding four second data packets 1402, and then the PDCP headers are added to the first encoded data packets 1404 to obtain six PDUs of the PDCP. A primary cell transmits three PDCP PDUs, and a secondary cell transmits three PDCP PDUs, where the three PDCP PDUs transmitted by the primary cell are represented by 1406A and the three PDCP PDUs transmitted by the secondary cell are represented by 1406B. The second transmission node receives the first encoded data packets 1 and 2 transmitted via the primary cell, and receives the first encoded data packets 4 and 5 transmitted via the secondary cell, where the first encoded data packet 5 is the third encoded data packet. The PDCP header is removed at the PDCP layer of the second transmission node, and the second data packets may be restored by decoding through an Exclusive-OR operation.

Scenario 2: taking the second data packets being acquired according to the SDU data packet of the PDCP layer under the CA scenario as an example for explanation.

Exemplarily, as shown in FIG. 6, FIG. 6 is a schematic diagram for encoding a data packet in a PDCP layer under a CA scenario provided in the embodiments of the present disclosure. Referring to FIG. 6, the first transmission node 1508 performs encoding on second data packets 1502, the number of second data packets 1502 is k, k is an integer greater than 0, and as shown in FIG. 6, k being 4 is shown as an example. The k second data packets 1502 are encoded according to the first generation matrix to obtain the n first encoded data packets 1504, n is an integer greater than k, and as shown in FIG. 6, n being 6 is shown as an example. Then the first encoded data packets 1504 are added PDCP headers to obtain the PDUs of the PDCP. In the CA scenario, the encoded PDUs of the PDCP are divided according to CSI-RS, DCI, and other channel state information, and are transmitted through different carriers. In FIG. 6, four second data packets 1502 are encoded to obtain six first encoded data packets 1504. Then, the PDCP headers are added to the first encoded data packets 1504 to obtain six PDUs of the PDCP. A first carrier transmits three PDCP PDUs of 1506A, and a second carrier transmits three PDCP PDUs of 1506B. The second transmission node receives the first encoded data packets 1 and 2 transmitted via the first carrier, as well as the first encoded data packets 4 and 5 transmitted via the second carrier. Herein, the first encoded data packet 5 is the third encoded data packet. The PDCP header is removed at the PDCP layer of the second transmission node, and the second data packets may be restored by decoding through an Exclusive-OR operation.

It should be noted that the first carrier and the second carrier are merely expressions for different carriers, there is no order relationship between them.

As another example, in a case where a second data packet comes from the RLC layer, the second data packet is obtained according to a SDU data packet of the RLC layer.

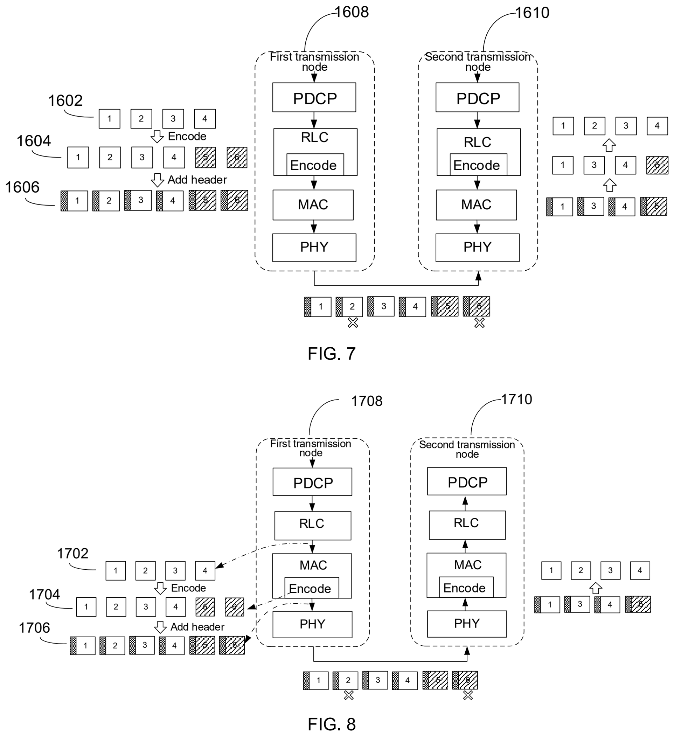

Exemplarily, as shown in FIG. 7, FIG. 7 is a schematic diagram for encoding a data packet in the RLC layer provided in the embodiments of the present disclosure. Referring to FIG. 7, the first transmission node 1608 performs encoding on second data packets 1602, the number of second data packets 1602 is k, k is an integer greater than 0, and as shown in FIG. 7, k being 4 is shown as an example. The k second data packets 1602 are encoded according to the first generation matrix to obtain the n first encoded data packets 1604, n is an integer greater than k, and as shown in FIG. 7, n being 6 is shown as an example. Then the first encoded data packets 1604 are added RLC headers to obtain the PDUs of the RLC. Then, the second transmission node 1610 receives the first encoded data packets 1, 3, 4, and 5, where the first encoded data packet 5 is a third encoded data packet. The RLC headers are removed at the RLC layer of the second transmission node 1610, and the second data packets may be restored by decoding by Exclusive-OR operation; where the white framed parts 1602 represent the second data packets, the black part on the left of 1606 represents the data packet headers, and the lower left slashed parts in 1604 and 1606 represent the second encoded data packets.

As another example, in a case where a second data packet comes from the MAC layer, the second data packet is obtained according to a SDU data packet of the MAC layer.

Exemplarily, as shown in FIG. 8, FIG. 8 is a schematic diagram for encoding a data packet in the MAC layer provided in the embodiments of the present disclosure. Referring to FIG. 8, the first transmission node 1708 performs encoding on second data packets 1702, the number of second data packets 1702 is k, k is an integer greater than 0, and as shown in FIG. 8, k being 4 is shown as an example. The k second data packets 1702 are encoded according to the first generation matrix to obtain the n first encoded data packets 1704, n is an integer greater than k, and as shown in FIG. 8, n being 6 is shown as an example. Then the first encoded data packets 1704 are added MAC headers to obtain the PDUs 1706 of the PDCP. Then, the second transmission node 1710 receives the first encoded data packets 1, 3, 4, and 5, where the first encoded data packet 5 is a third encoded data packet. The MAC headers are removed at the MAC layer of the second transmission node 1710, and the second data packets may be restored by decoding by Exclusive-OR operation; where the white framed parts 1702 represent the second data packets, the black part on the left of 1706 represents the data packet headers, and the lower left slashed parts in 1704 and 1706 represent the second encoded data packets.

As another example, in a case where a second data packet comes from a physical layer, the second data packets are obtained according to a transmission block of the physical layer, and each second data packet corresponds to a code block.

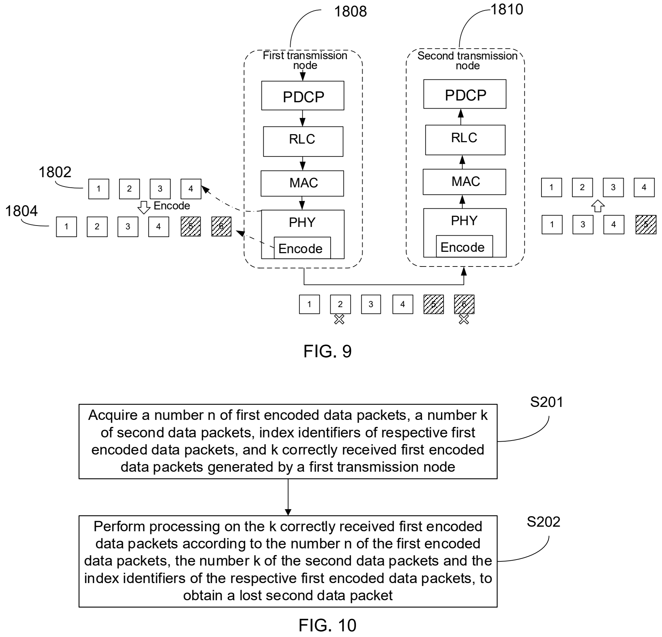

For example, as shown in FIG. 9, FIG. 9 is a schematic diagram for encoding a code block in a physical layer provided in the embodiments of the present disclosure. The first transmission node 1808 performs encoding on second data packets 1802, the number of second data packets 1802 is k, k is an integer greater than 0, and as shown in FIG. 9, k being 4 is shown as an example. The k second data packets 1802 are encoded according to the first generation matrix to obtain the n first encoded data packets 1804, n is an integer greater than k, and as shown in FIG. 5, n being 6 is shown as an example. Then, the second transmission node 1810 receives the first encoded data packets 1, 3, 4, and 5, and the second data packet may restored by decoding through an Exclusive-OR operation. Herein, the first encoded data packet 5 is a third encoded data packet.

In S104, all of the first encoded data packets or a portion of first encoded data packets among the n first encoded data packets are sent to a second transmission node.

In some embodiments, a first encoded data packet includes an index identifier I(u), and an index identifier I(u) of a first encoded data packet is used to characterize an order of the first transmission node generating the first encoded data packet, and/or used to characterize positions of the k second data packets in the n first encoded data packets. Herein, $0 \leq u \leq n - 1$, and I(u) is a non-negative integer.

In a case where an index identifier I(u) of a first encoded data packet is used to characterize the order of the first transmission node generating the first encoded data packets, as an example, the n first encoded data packets $d = [d_0, d_1,...,d_{n-1}]$ correspond to index identifiers $< I(0),I(1),...,I(n - 1) > = < 0,1,...,n - 1 >$ in sequence. As another example, the n first encoded data packets $d = [d_0,d_1,...,d_{n-1}]$ correspond to index identifiers $< I(1),I(2),...,I(n) > = < 1,2,...,n >$ in sequence.

In a case where an index identifier I(u) of a first encoded data packet is used to characterize positions of the k second data packets in the n first encoded data packets, as an example, index identifiers are $< I(0),I(1),...,I(n - 1) > = < 0,1,...,n - 1 >$, while $< I(0),I(1),...,I(_k - 1) > = < 0,1,...,k - 1 >$ represent index identifiers of the k second data packets. As another example, the index identifiers are $< I(0),I(1),...,I(n - 1) > = < 1,2,...,n >$, while $< I(0),I(1),...,I(_k - 1) > = < 1,2,...,k >$ represent index identifiers of the k second data packets.

In some embodiments, an index identifier of a first encoded data packet may be carried in header information of the first encoded data packet, that is, the index identifier of the first encoded data packet transmitted by the first transmission node may be carried and transmitted via the header information. It should be understood that the index identifier of the first encoded data packet is carried in the header information, which can ensure that the second transmission node can stably and reliably receive the index identifier of the first encoded data packet, thereby ensuring the stability of data transmission.

In some embodiments, the first transmission node may send all of the first encoded data packets or a portion of first encoded data packets among the n first encoded data packets to a second transmission node through M links, and a number M_i of first encoded data packets sent through an i-th link among the M links is smaller than or equal to n, M is a positive integer, and i is a positive integer smaller than or equal to M. In an example, M is equal to 1, 2, or 4.

For example, in a case where M is equal to 1, all of the first encoded data packets or a portion of first encoded data packets among the n first encoded data packets are transmitted to the second transmission node through one link.

For another example, in a case where M is greater than 1, each link sends the same number of first encoded data packets, that is, each link sends n/M first encoded data packets.

In some embodiments, the first transmitting node may further determine the number of first encoded data packets to be transmitted over a link according to a channel quality of a link. For example, the channel quality of the link is positively correlated with the number of first encoded data packets transmitted through the link, that is, the better the channel quality of the link, the more first data packets are transmitted.

Taking the channel quality of a link being an average packet loss rate of the link as an example, for example, taking M being equal to 2 as an example, an average packet loss rate of a first link is $P_1$, an average packet loss rate of a second link is $P_2$, a number $M_1$ of first encoded data packets transmitted through the first link may be $M_1 = n * P_2/(P_1 + P_2)$, and a number $M_2$ of first encoded data packets transmitted through the second link may be $M_2 = n * P_1/(P_1 + P_2)$.

It should be understood that in S104, the first transmission node transmits a portion of the first encoded data packets or all of the first encoded data packets among the n first encoded data packets to the second transmission node, so that the second transmission node receives enough first encoded data packets for processing. That is, since the first transmission node only needs to send the corresponding first encoded data packets to the second transmission node, the second transmission node can effectively complete decoding, avoiding the delay caused by the retransmission of data packets. In a case where only one second data packet is lost at the second transmission node and the third encoded data packet is correctly received, the lost second data packet may be restored through a simple Exclusive-OR operation, thereby ensuring the reliability of data transmission and reducing resource overhead.

The embodiment shown in FIG. 2 brings at least the following beneficial effects: by converting the m first data packets into k second data packets, the k second data packets are made to be the same size, so that the k second data packets can be smoothly encoded according to the first generation matrix to obtain the n first encoded data packets, thereby ensuring the reliability of data transmission. The n first encoded data packets are obtained by encoding the k second data packets according to the first generation matrix. Since any k rows in the first generation matrix are linearly independent under the Galois field GF(q), it is ensured that when any r first encoded data packets among the n first encoded data packets are faulty, the k second data packets can be successfully obtained by decoding, so that the encoding operation amount can be reduced without reducing storage reliability, that is, resource overhead is reduced. And there is a target row in the second generation matrix, so that the faulty first encoded data packet can be restored through a simple Exclusive-OR operation, reducing the computational load and resource overhead, thus ensuring the reliability of data transmission and reducing resource overhead.

In some embodiments, as shown in FIG. 10, a data processing method is provided in the embodiments of the present disclosure, and the method is applied to a second transmission node. The second transmission node may be the second transmission node 120 shown in the above-mentioned FIG. 1. The method includes the following S201 to S202.

In S201, a number n of first encoded data packets, a number k of second data packets, index identifiers of respective first encoded data packets, and k correctly received first encoded data packets generated by a first transmission node are received.

Herein, n and k are positive integers, and the k correctly received first encoded data packets are a subset of the n first encoded data packets.

In S202, processing on the k correctly received first encoded data packets is performed according to the number n of the first encoded data packets, the number k of the second data packets and the index identifiers of the respective first encoded data packets, to obtain a lost second data packet.

As a possible example, S202 may include the following operations.

In S1, first encoded data packets that are failed to be received are determined according to the number of the first encoded data packets, the index identifiers of the respective first encoded data packets, and the k correctly received first encoded data packets.

It should be understood that the number of first encoded data packets is a number of first encoded data packets sent from the first transmission node to the second transmission node. According to the number of first encoded data packets, the index identifiers of the respective first encoded data packets and the number k of second data packets, index identifiers of the first encoded data packets that are failed to be received may be determined, and then second data packets that are failed to be received may be restored based on the k correctly received first encoded data packets.

After determining the index identifiers of the first encoded data packets that are failed to be received, at least one of the following S2 to S4 may be included.

In S2, in response to that the first encoded data packets that are failed to be received include one second data packet, and the second transmission node receives a third encoded data packet, an Exclusive-OR processing is performed on (k-1) received second data packets and the third encoded data packet to obtain the lost second data packet.

As set forth above, the third encoded data packet is a data packet obtained by performing encoding processing on the second data packets according to a target row in the second generation matrix, and values of elements in the target row are all 1.

In S3, in response to that the first encoded data packets that are failed to be received merely include one second data packet, and the second transmission node receives other second encoded data packets excluding the third encoded data packet, the lost second data packet is determined according to Gaussian elimination or at least one of the following parameters: the second generation matrix, the (k-1) received second data packets, one received second encoded data packet, and index identifiers of the k received first encoded data packets.

In S4, in response to that the first encoded data packets that are failed to be received include p second data packets and the second transmission node receives at least p second encoded data packets, the lost second data packet is determined according to the Gaussian elimination or at least one of the following parameters: the second generation matrix, the (k-p) received second data packets, the at least p received second encoded data packets, and the index identifiers of the k received first encoded data packets.

Herein, p is an integer greater than 1 and smaller than or equal to r.

It should be understood that in a case where the number of the first encoded data packets that are failed to be received exceeds r, data recovery cannot be completed, where r=n-k, and r is a positive integer. In a case where the number of first encoded data packets that are failed to be received is 0, data is not lost, and data recovery is not required. In a case where the first encoded data packets that are failed to be received include 0 second encoded data packet, the data is not lost, and data recovery is not required.

It should be noted that S2, S3 and S4 are only descriptions for different situations, and there is no order relationship between S2, S3 and S4.

The embodiment shown in FIG. 10 brings at least the following beneficial effects: in a case where the number of first encoded data packets that are failed to be received does not exceed r, the second transmission node obtains the second data packets that are failed to be received based on the k correctly received first encoded data packets. Since any k rows of the first generation matrix are linearly independent, it is only necessary to obtain any k first encoded data packets and complete data recovery through a simple Exclusive-OR operation without acquiring more than k first encoded data packets, thereby ensuring the reliability and throughput of data transmission and reducing resource overhead.

The foregoing mainly introduces the solutions provided by the present disclosure from the perspective of interaction between various nodes. It can be understood that, in order to implement the above-mentioned functions, the various nodes (e.g., the first transmission node and the second transmission node) include corresponding hardware structures and/or software modules for performing the various functions. Those skilled in the art should easily realize that the present disclosure may be implemented in the form of hardware or a combination of hardware and computer software in combination with algorithms and steps described in the embodiments disclosed in the present disclosure. Whether a certain function is implemented by hardware or by computer software driving hardware depends on the specific application and design constraint conditions of the technical solutions. Professional technicians may use different methods to implement the described functions for each specific application, but such implementation should not be considered beyond the scope of the present disclosure.

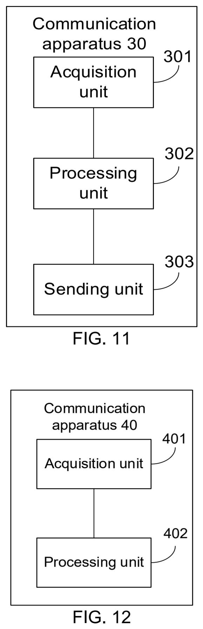

As shown in FIG. 11, FIG. 11 is a schematic diagram of composition of a communication apparatus provided in the embodiments of the present disclosure. As shown in FIG. 11, the communication apparatus 30 includes an acquisition unit 301, a processing unit 302 and a sending unit 303.

The communication apparatus 30 may be the above-mentioned first transmission node or a chip in the first transmission node. In a case where the communication apparatus 30 is configured to implement functions of the first transmission node in the above embodiments, various units are specifically used to implement the following functions.

The acquisition unit 301 is configured to acquire m first data packets, where m is a positive integer.

The processing unit 302 is configured to determine k second data packets according to the m first data packets, where k is a positive integer.

The processing unit 302 is further configured to perform encoding processing on the k second data packets according to a first generation matrix to obtain n first encoded data packets, where n is a positive integer, and a value range of elements in the first generation matrix is [0, q-1], and q is a prime number or a power of a prime number.

The sending unit 303 is configured to send all of the first encoded data packets or a portion of first encoded data packets among the n first encoded data packets to a second transmission node.

In some embodiments, the m first data packets includes at least one of: a data packet of a packet data convergence protocol (PDCP) layer in a wireless interface protocol stack; a data packet of a radio link control (RLC) layer in the wireless interface protocol stack; a data packet of a medium access control (MAC) layer in the wireless interface protocol stack; or a data packet of a physical layer in the wireless interface protocol stack.

In some embodiments, the processing unit 302 is specifically configured to: in response to the m first data packets being a same size, take the m first data packets as the k second data packets, where m=k; or in response to the m first data packets not being the same size, fill sizes of first data packets among the m first data packets excluding a target first data packet to a same size as a size of the target first data packet, so as to obtain the k second data packets, where the target first data packet is a data packet with a largest size among the m first data packets, and m=k.

In some embodiments, the processing unit 302 is specifically configured to: perform pre-processing on the m first data packets to obtain the k second data packets, where the pre-processing includes at least one of: combining processing, filling processing, or segmenting processing.

In some embodiments, a number k of the second data packets is determined according to at least one of: a number m of the first data packets, a size S of the m first data packets, a size T of a second data packet, channel state information, capability information of a user equipment, a control signaling, a number of links and a number of carriers; where the channel state information includes at least one of: channel quality indication information, rank indication information or precoding matrix indication information; the capability information of the user equipment includes at least one of: an upper limit value of a number of antennas supported by the user equipment, an upper limit value of a data transmission rate supported by the user equipment, or an upper limit value of a modulation order supported by the user equipment.

In some embodiments, in response to the channel state information being the channel quality indication information, the number k of the second data packets is determined according to an index value of the channel quality indication information; in response to the channel state information being the rank indication information, the number k of the second data packets is determined according to a value of the rank indication information; or in response to the channel state information being the precoding matrix indication information, the number k of the second data packets is determined according to an index value of the precoding matrix indication information.

In some embodiments, the first generation matrix is determined according to one of: being determined according to a pre-configuration; or being determined according to a number k of the second data packets and/or a number n of the first encoded data packets.

In some embodiments, the first generation matrix includes an identity matrix and a second generation matrix, a size of the identity matrix is k×k, a size of the second generation matrix is r×k, and n=r+k, r is a positive integer; the n first encoded data packets include k second data packets and r second encoded data packets, and the r second encoded data packets are data packets obtained by performing encoding on the k second data packets according to the second generation matrix.

In some embodiments, a number r of the second encoded data packets is determined according to at least one of: a number k of the second data packets, channel state information, and a control signaling; where the channel state information includes at least one of: channel quality indication information, rank indication information, or precoding matrix indication information.

In some embodiments, for any k rows in the first generation matrix, the any k rows are linearly independent under the Galois Field GF(q); where q is a prime number or a power of a prime number.

In some embodiments, for any r columns in a merged matrix consisting of the second generation matrix and the identity matrix with a size of r×r, the any r columns are linearly independent under the Galois Field GF(q); where q is a prime number or a power of a prime number.

In some embodiments, there is a target row in the second generation matrix, and values of elements in the target row are all 1.

In some embodiments, a value of an element with a row number i and a column number j in the second generation matrix is determined according to the following parameters: k, i, j; where i and j are both non-negative integers, and 0≤i≤r-1, 0≤j≤k-1.

In some embodiments, the value of the element with the row number i and the column number j in the second generation matrix is determined according to the following formula:

$$g_{i,j} = (k + j)/(k + i + j);$$

where $g_{i,j}$ represents the value of the element with the row number i and the column number j in the second generation matrix, i and j are both non-negative integers, and 0≤i≤r-1, 0≤j≤k-1, / represents a division operation under the Galois field GF(q), and + represents a bitwise Exclusive-OR operation under the Galois field GF(q).

In some embodiments, the value of the element with the row number i and the column number j in the second generation matrix is determined according to the following formula:

$$g_{i,j} = ((k + j) * (k + i))/((k + i + j) * k);$$

where $g_{i,j}$ represents the value of the element with the row number i and the column number j in the second generation matrix, / represents a division operation under the Galois field GF(q), and + represents a bitwise Exclusive-OR operation under the Galois field GF(q), * represents a multiplication operation under the Galois field GF(q), and q is a prime number or a power of a prime number.

In some embodiments, any two rows or columns in the second generation matrix are capable of being exchanged.

In some embodiments, the n first encoded data blocks are determined according to the following formula:

$$d = G * a;$$

where d represents the n first encoded data blocks, G represents the first generation matrix, * represents a multiplication operation under the Galois field GF(q), *a* represents the k second data packets, and q is a prime number or a power of a prime number.

In some embodiments, a first encoded data packet includes an index identifier, and the index identifier is used to characterize an order of the first transmission node generating the first encoded data packet, and/or used to characterize positions of the k second data packets in the n first encoded data packets.

In some embodiments, the index identifier of the first encoded data packet is carried in header information of the first encoded data packet.

As shown in FIG. 12, FIG. 12 is a schematic diagram of composition of another communication apparatus provided in the embodiments of the present disclosure. As shown in FIG. 12, the communication apparatus 40 includes an acquisition unit 401 and a processing unit 402.

The communication apparatus 40 may be the above-mentioned second transmission node or a chip in the second transmission node. In a case where the communication apparatus 40 is configured to implement functions of the second transmission node in the above embodiments, various units are specifically used to implement the following functions.

The acquisition unit 401 is configured to acquire a number n of first encoded data packets, a number k of second data packets, index identifiers of respective first encoded data packets, and k correctly received first encoded data packets generated by a first transmission node; where k is a positive integer, and the k correctly received first encoded data packets are a subset of the n first encoded data packets obtained by the first transmission node performing encoding on the k second data packets according to a first generation matrix.

The processing unit 402 is configured to perform processing on the k correctly received first encoded data packets according to the number n of the first encoded data packets, the number k of the second data packets and the index identifiers of the respective first encoded data packets, to obtain a lost second data packet.

In some embodiments, the processing unit 402 is specifically configured to: determine index identifiers of first encoded data packets that are failed to be received according to the number of the first encoded data packets, the index identifiers of the respective first encoded data packets, and the number k of the second data packets;

in response to that the first encoded data packets that are failed to be received include one second data packet, and the second transmission node receives a third encoded data packet, perform an Exclusive-OR processing on (k-1) received second data packets and the third encoded data packet to obtain the lost second data packet; where the third encoded data packet is a data packet obtained by performing encoding processing on the second data packets according to a target row in the second generation matrix, and values of elements in the target row are all 1;

in response to that the first encoded data packets that are failed to be received merely include one second data packet, and the second transmission node receives other second encoded data packets excluding the third encoded data packet, determine the lost second data packet according to Gaussian elimination or at least one of the following parameters: the second generation matrix, the (k-1) received second data packets, one received second encoded data packet, and index identifiers of the k received first encoded data packets; or

in response to that the first encoded data packets that are failed to be received include p second data packets and the second transmission node receives at least p second encoded data packets, determine the lost second data packet according to the Gaussian elimination or at least one of the following parameters: the second generation matrix, the (k-p) received second data packets, the at least p received second encoded data packets, and the index identifiers of the k received first encoded data packets; where p is an integer greater than 1 and smaller than or equal to r.

It should be noted that the units in FIG. 11 and FIG. 12 may also be referred to as modules. For example, a sending unit may be referred to as a sending module. In addition, in the embodiments shown in FIG. 11 and FIG. 12, the names of the various units may not be the names shown in the figures. For example, the sending unit may also be referred to as a communication unit, and the acquisition unit may also be referred to as a communication unit.

If the various units in FIG. 11 and FIG. 12 are implemented in the form of the software functional unit and sold or used as independent products, they may be stored in a computer-readable storage medium. Based on this understanding, the technical solutions of the present disclosure may be essentially, or a part of the technical solutions of the present disclosure that contributes to the related technologies, or all or a portion of the technical solutions of the present disclosure may be, embodied in the form of a software product, and the computer software product may be stored in a storage medium including couples of instructions to enable a computer device (may be a personal computer, a server, a network device, etc.) or a processor to perform all or a portion of steps of the method in the various embodiments of the present disclosure. The storage medium for storing a computer software product includes various types of media capable of storing program codes, such as a USB flash drive, a mobile disk, a read-only memory (ROM), a Random-access memory (RAM), a magnetic disk, or an optical disk.

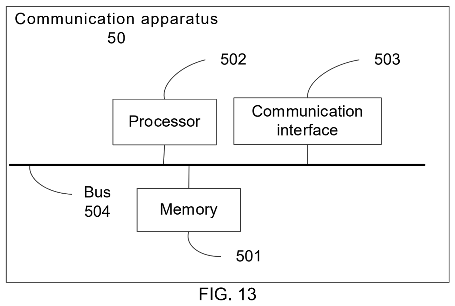

In a case where the communication apparatus 30 or the communication apparatus 40 implements the functions of the above-mentioned integrated modules by adopting the form of hardware, there is provided a structural schematic diagram of a communication apparatus in the embodiments of the present disclosure. As shown in FIG. 13, the communication apparatus 50 includes: a processor 502, a communication interface 503, and a bus 504. Optionally, the communication apparatus 50 may further include a memory 501.

The processor 502 may be implemented as or performed as various illustrative logical blocks, modules and circuits described in conjunction with disclosed contents of the present disclosure. The processor 502 may be a central processor, a general-purpose processor, a digital signal processor, an application specific integrated circuit, a field programmable gate array, or other programmable logic component, a transistor logic component, a hardware assembly, or any combination thereof. The processor 502 may implement or execute various illustrative logical blocks, modules and circuits described in conjunction with the disclosed contents of the present disclosure. The processor 502 may also be a combination that implements computing functions, for example, the processor 502 includes a combination of one or more microprocessors, a combination of a DSP (digital signal processor) and a microprocessor, or the like.

The communication interface 503 is configured to connect with other devices through a communication network. The communication network may be the Ethernet, a radio access network, a wireless local area network (WLAN), or the like.

The memory 501 may be a read-only memory (ROM) or other types of static storage devices that can store static information and instructions, a random access memory (RAM), or other types of dynamic storage devices that can store information and instructions, or an electrically erasable programmable read-only memory (EEPROM), a magnetic disk storage medium or any other magnetic storage devices, or any other medium that can be used to carry or store desired program codes with instructions or data and can be accessed by a computer, which is not limited thereto.

As a possible implementation, the memory 501 may exist independently from the processor 502, and the memory 501 may be connected to the processor 502 through the bus 504 for storing instructions or program codes. When the processor 502 invokes and executes the instructions or program codes stored in the memory 501, the processor 502 may implement the data processing method provided in the embodiments of the present disclosure.

In another possible implementation, the memory 501 may be integrated with the processor 502.

The bus 504 may be an extended industry standard architecture (EISA) bus, or the like. The bus 504 may be classified as an address bus, a data bus, a control bus, or the like. For ease of representation, only one bold line is used in FIG. 13 for representing the bus 504, which however does not mean that there is only one bus or one type of bus.

Through the description of the above implementations, those of ordinary skill in the art may clearly understand that for the convenience and simplicity of the description, the division of the above functional modules is given merely as an example. In practical applications, the above functions can be allocated to different functional modules according to requirements, that is, the internal structure of the base station or terminal may be divided into different functional modules to complete all or part of the functions described above.

A computer-readable storage medium is further provided in the embodiments of the present disclosure. All or part of the processes in the above method embodiments may be implemented by relevant information of an information hardware instructed by computer instructions. The programs may be stored in the above-mentioned computer-readable storage medium, and when executed, the programs may include the processes as described in the above method embodiments. The computer-readable storage medium may be an internal storage in any of the aforementioned embodiments. The above-mentioned computer-readable storage medium may also be an external storage device of the above-mentioned base station or terminal, such as a plug-in hard disk, a smart media card (SMC), a secure digital (SD) card, a flash card, etc., equipped on the above-mentioned base station or terminal. Furthermore, the above-mentioned computer-readable storage medium may include both an internal storage unit and an external storage device of the above-mentioned base station or terminal. The above-mentioned computer-readable storage medium is configured to store the above-mentioned computer programs and other programs and data required by the above-mentioned base station or terminal. The above-mentioned computer-readable storage medium may further be configured to temporarily store data that has been output or is to be output.

A computer program product is further provided in the embodiments of the present disclosure. The computer program product includes computer programs that, upon being run on a computer, enable the computer to perform any one of the data processing methods provided in the above-mentioned embodiments.

Although the present disclosure is described herein in conjunction with various embodiments, other variations of the disclosed embodiments may be understood and implemented by those skilled in the art by viewing the accompanying drawings, the disclosed contents, and the attached claims during the implementation of the present disclosure claimed to be protected. In the claims, "comprise/comprises/comprising" does not exclude other components or steps, and "a/an" or "one" does not exclude a number of a plurality. A single processor or other units may implement couples of functions listed in the claims. Some measures are recorded in different dependent claims, but this does not mean that these measures cannot be combined to produce good effects.

Although the present disclosure is described in conjunction with specific features and embodiments thereof, obviously, various modifications and combinations can be made thereto without departing from the spirit and scope of the present disclosure. Accordingly, the specification and accompanying drawings herein are merely exemplary illustration of the present disclosure defined by the claims and are deemed to cover any and all modifications, variations, combinations or equivalents within the scope of the present disclosure. Obviously, those skilled in the art can make various modifications and variations to the present disclosure without departing from the spirit and scope of the present disclosure. In this way, if these modifications and variations of the present disclosure fall within the scope of the claims of the present disclosure and their equivalent technologies, the present disclosure is also intended to include these modifications and variations.

The above descriptions are merely specific implementations of the present disclosure, but the protection scope of the present disclosure is not limited thereto, and any variations or replacements within the technical scope disclosed in the present disclosure shall fall within the protection scope of the present disclosure. Therefore, the protection scope of the present disclosure should be subject to the protection scope of the claims.

**Claims**

1. A data processing method, **characterized by** being applied to a first transmission node, wherein the method comprises:

   acquiring m first data packets, wherein m is a positive integer;
   determining k second data packets according to the m first data packets, wherein k is a positive integer;
   performing encoding processing on the k second data packets according to a first generation matrix to obtain n first encoded data packets, wherein n is a positive integer, and a value range of elements in the first generation matrix is [0, q-1], and q is a prime number or a power of a prime number; and
   sending all of the first encoded data packets or a portion of first encoded data packets among the n first encoded data packets to a second transmission node.

2. The method according to claim 1, wherein the m first data packets comprises at least one of:

   a data packet of a packet data convergence protocol (PDCP) layer in a wireless interface protocol stack;
   a data packet of a radio link control (RLC) layer in the wireless interface protocol stack;
   a data packet of a medium access control (MAC) layer in the wireless interface protocol stack; or
   a data packet of a physical layer in the wireless interface protocol stack.

3. The method according to claim 1, wherein determining the k second data packets according to the m first data packets comprises at least one of:

   in response to the m first data packets being a same size, taking the m first data packets as the k second data packets, wherein m=k; or
   in response to the m first data packets not being the same size, filling sizes of first data packets among the m first data packets excluding a target first data packet to a same size as a size of the target first data packet, so as to obtain the k second data packets, wherein the target first data packet is a data packet with a largest size among the m first data packets, and m=k.

4. The method according to claim 1, wherein determining the k second data packets according to the m first data packets comprises:
   performing pre-processing on the m first data packets to obtain the k second data packets, wherein the pre-processing comprises at least one of: combining processing, filling processing, or segmenting processing.

5. The method according to claim 1, wherein a number k of the second data packets is determined according to at least one of:
   a number m of the first data packets, a size S of the m first data packets, a size T of a second data packet, channel state information, capability information of a user equipment, a control signaling, a number of links and a number of carriers; wherein the channel state information comprises at least one of: channel quality indication information, rank indication information or precoding matrix indication information; the capability information of the user equipment comprises at least one of: an upper limit value of a number of antennas supported by the user equipment, an upper limit value of a data transmission rate supported by the user equipment, or an upper limit value of a modulation order supported by the user equipment.

6. The method according to claim 5, wherein

in response to the channel state information being the channel quality indication information, the number k of the second data packets is determined according to an index value of the channel quality indication information; in response to the channel state information being the rank indication information, the number k of the second data packets is determined according to a value of the rank indication information; or in response to the channel state information being the precoding matrix indication information, the number k of the second data packets is determined according to an index value of the precoding matrix indication information.

7. The method according to claim 1, wherein the first generation matrix is determined according to one of:

being determined according to a pre-configuration; or being determined according to a number k of the second data packets and/or a number n of the first encoded data packets.

8. The method according to claim 1, wherein the first generation matrix comprises an identity matrix and a second generation matrix, a size of the identity matrix is k×k, a size of the second generation matrix is r×k, and n=r+k, r is a positive integer;
the n first encoded data packets comprise k second data packets and r second encoded data packets, and the r second encoded data packets are data packets obtained by performing encoding on the k second data packets according to the second generation matrix.

9. The method according to claim 8, wherein a number r of the second encoded data packets is determined according to at least one of:
a number k of the second data packets, channel state information, and a control signaling; wherein the channel state information comprises at least one of: channel quality indication information, rank indication information, or precoding matrix indication information.

10. The method according to claim 1, wherein for any k rows in the first generation matrix, the any k rows are linearly independent under the Galois Field GF(q); wherein q is a prime number or a power of a prime number.

11. The method according to claim 8, wherein for any r columns in a merged matrix consisting of the second generation matrix and the identity matrix with a size of r×r, the any r columns are linearly independent under the Galois Field GF(q); wherein q is a prime number or a power of a prime number.

12. The method according to claim 8, wherein there is a target row in the second generation matrix, and values of elements in the target row are all 1.

13. The method according to claim 8, wherein a value of an element with a row number i and a column number j in the second generation matrix is determined according to the following parameters: k, i, j; wherein i and j are both non-negative integers, and $0 \leq i \leq r-1$, $0 \leq j \leq k-1$.

14. The method according to claim 13, wherein the value of the element with the row number i and the column number j in the second generation matrix is determined according to the following formula:

$$g_{i,j} = (k + j)/(k + i + j);$$

wherein $g_{i,j}$ represents the value of the element with the row number i and the column number j in the second generation matrix, i and j are both non-negative integers, and $0 \leq i \leq r-1$, $0 \leq j \leq k-1$, / represents a division operation under the Galois field GF(q), and + represents a bitwise Exclusive-OR operation under the Galois field GF(q).

15. The method according to claim 13, wherein the value of the element with the row number i and the column number j in the second generation matrix is determined according to the following formula:

$$g_{i,j} = ((k + j) * (k + i))/((k + i + j) * k);$$

wherein $g_{i,j}$ represents the value of the element with the row number i and the column number j in the second generation matrix, / represents a division operation under the Galois field GF(q), and + represents a bitwise Exclusive-OR operation under the Galois field GF(q), * represents a multiplication operation under the Galois field GF(q), and q is a prime number or a power of a prime number.

16. The method according to claim 14 or 15, wherein any two rows or columns in the second generation matrix are capable of being exchanged.

17. The method according to claim 1, wherein the n first encoded data blocks are determined according to the following formula:

$$d = G * a;$$

wherein $d$ represents the n first encoded data blocks, $G$ represents the first generation matrix, * represents a multiplication operation under the Galois field GF(q), $a$ represents the k second data packets, and q is a prime number or a power of a prime number.

18. The method according to claim 1, wherein a first encoded data packet comprises an index identifier, and the index identifier is used to characterize an order of the first transmission node generating the first encoded data packet, and/or used to characterize positions of the k second data packets in the n first encoded data packets.

19. The method according to claim 18, wherein the index identifier of the first encoded data packet is carried in header information of the first encoded data packet.

20. A data processing method, **characterized by** being applied to a second transmission node, wherein the method comprises:

acquiring a number n of first encoded data packets, a number k of second data packets, index identifiers of respective first encoded data packets, and k correctly received first encoded data packets generated by a first transmission node; wherein n and k are positive integers, and the k correctly received first encoded data packets are a subset of the n first encoded data packets obtained by the first transmission node performing encoding on the k second data packets according to a first generation matrix; and
performing processing on the k correctly received first encoded data packets according to the number n of the first encoded data packets, the number k of the second data packets and the index identifiers of the respective first encoded data packets, to obtain a lost second data packet.

21. The method according to claim 20, wherein the first generation matrix comprises an identity matrix and a second generation matrix, a size of the identity matrix is k×k, a size of the second generation matrix is r×k, and n=r+k, r is a positive integer;
performing processing on the k correctly received first encoded data packets to obtain the lost second data packet comprises:

determining index identifiers of first encoded data packets that are failed to be received according to the number of the first encoded data packets, the index identifiers of the respective first encoded data packets, and the number k of the second data packets;
in response to that the first encoded data packets that are failed to be received comprise one second data packet, and the second transmission node receives a third encoded data packet, performing an Exclusive-OR processing on (k-1) received second data packets and the third encoded data packet to obtain the lost second data packet; wherein the third encoded data packet is a data packet obtained by performing encoding processing on the second data packets according to a target row in the second generation matrix, and values of elements in the target row are all 1;
in response to that the first encoded data packets that are failed to be received merely comprise one second data packet, and the second transmission node receives other second encoded data packets excluding the third encoded data packet, determining the lost second data packet according to Gaussian elimination or at least one of the following parameters: the second generation matrix, the (k-1) received second data packets, one received second encoded data packet, and index identifiers of the k received first encoded data packets; or

in response to that the first encoded data packets that are failed to be received comprise p second data packets and the second transmission node receives at least p second encoded data packets, determining the lost second data packet according to the Gaussian elimination or at least one of the following parameters: the second generation matrix, the (k-p) received second data packets, the at least p received second encoded data packets, and the index identifiers of the k received first encoded data packets; wherein p is an integer greater than 1 and smaller than or equal to r.

22. A communication apparatus, **characterized by** comprising: a processor and a memory;

the memory stores instructions that are executable for the processor;
the processor is configured to, upon executing the instructions, cause the communication apparatus to implement the method according to any one of claims 1 to 21.

23. A computer-readable storage medium, wherein the computer-readable storage medium comprises computer instructions, the computer instructions, upon being run on a computer, cause the computer to perform the method according to any one of claims 1 to 21.

FIG. 1

S101

Acquire m first data packets

S102

Determine k second data packets according to the m first data packets

S103

Encode the k second data packets according to a first generator matrix to obtain n first encoded data packets

S104

Send all or some first encoded data packets among the n first encoded data packets to a second transmission node

FIG. 2

$$G = \begin{bmatrix} I \\ G_2 \end{bmatrix} = \begin{bmatrix} 1 & 0 & 0 & \cdots & 0 \\ 0 & 1 & 0 & \cdots & 0 \\ \vdots & \vdots & \vdots & & \vdots \\ 0 & 0 & 0 & \cdots & 1 \\ g_{0,0} & g_{0,1} & g_{0,2} & \cdots & g_{0,k-1} \\ g_{1,0} & g_{1,1} & g_{1,2} & \cdots & g_{1,k-1} \\ \vdots & \vdots & \vdots & & \vdots \\ g_{r-1,0} & g_{r-1,1} & g_{r-1,2} & \cdots & g_{r-1,k-1} \end{bmatrix}$$

1201

1202

1200

FIG. 3

1308

1310

1302

1304

1306

First transmission node

PDCP

Encode

RLC

MAC

PHY

Second transmission node

PDCP

Encode

RLC

MAC

PHY

Encode

Add header

FIG. 4

FIG. 5

FIG. 6

FIG. 7

FIG. 8

FIG. 9

Acquire a number n of first encoded data packets, a number k of second data packets, index identifiers of respective first encoded data packets, and k correctly received first encoded data packets generated by a first transmission node — S201

Perform processing on the k correctly received first encoded data packets according to the number n of the first encoded data packets, the number k of the second data packets and the index identifiers of the respective first encoded data packets, to obtain a lost second data packet — S202

FIG. 10

FIG. 11

FIG. 12

Communication apparatus
50

502

503

Processor

Communication
interface

Bus
504

Memory

501

FIG. 13

## INTERNATIONAL SEARCH REPORT

| International application No. |
|---|
| **PCT/CN2024/076012** |

### A.   CLASSIFICATION OF SUBJECT MATTER

H04L 1/00(2006.01)i

According to International Patent Classification (IPC) or to both national classification and IPC

### B.   FIELDS SEARCHED

Minimum documentation searched (classification system followed by classification symbols)

IPC: H04L

Documentation searched other than minimum documentation to the extent that such documents are included in the fields searched

Electronic data base consulted during the international search (name of data base and, where practicable, search terms used)

CNTXT, VEN, ENTXT, 3GPP, CJFD, IEEE: 编码, 解码, 译码, 数据, 包, 矩阵, 相同, 能力, encode, decode, data, packet, matrix, same, capability

### C.   DOCUMENTS CONSIDERED TO BE RELEVANT

| Category* | Citation of document, with indication, where appropriate, of the relevant passages | Relevant to claim No. |
|---|---|---|
| Y | CN 112751644 A (TENCENT TECHNOLOGY (SHENZHEN) CO., LTD.) 04 May 2021 (2021-05-04) description, paragraphs 0048-0130 | 1-13, 17-20, 22-23 |
| Y | CN 115913453 A (HUAWEI TECHNOLOGIES CO., LTD.) 04 April 2023 (2023-04-04) description, paragraphs 0040-0080 | 1-13, 17-20, 22-23 |
| A | CN 115549850 A (HUAWEI TECHNOLOGIES CO., LTD.) 30 December 2022 (2022-12-30) entire document | 1-23 |
| A | WO 2015120758 A1 (TENDYRON CORP.) 20 August 2015 (2015-08-20) entire document | 1-23 |

☐ Further documents are listed in the continuation of Box C.          ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **16 May 2024** | **21 May 2024** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

| International application No. |
| PCT/CN2024/076012 |

| Patent document cited in search report | | | Publication date (day/month/year) | Patent family member(s) | Publication date (day/month/year) |
|---|---|---|---|---|---|
| CN | 112751644 | A | 04 May 2021 | None | |
| CN | 115913453 | A | 04 April 2023 | None | |
| CN | 115549850 | A | 30 December 2022 | None | |
| WO | 2015120758 | A1 | 20 August 2015 | None | |

Form PCT/ISA/210 (patent family annex) (July 2022)

**EP 4 718 756 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310674811